# EUROPÄISCHE PATENTSCHRIFT

(11) **EP 1 337 496 B1**
(45) Veröffentlichungstag und Bekanntmachung des Hinweises auf die Patenterteilung: **08.08.2007**
(21) Anmeldenummer: 01998516.7
(22) Anmeldetag: 27.11.2001
(51) Int. Cl.: C04B 35/50, C04B 35/48, C04B 35/624, H01M 8/12, C01B 13/18

(54) **KERAMISCHER WERKSTOFF SOWIE DESSEN HERSTELLUNG**
CERAMIC MATERIAL AND THE PRODUCTION THEREOF
MATERIAU CERAMIQUE ET SA PRODUCTION

(30) Priorität: 29.11.2000 DE 10059280
(43) Veröffentlichungstag der Anmeldung: 27.08.2003
(73) Patentinhaber: Forschungszentrum Jülich GmbH, 52425 Jülich (DE)
(72) Erfinder: TIETZ, Frank, 52428 Jülich (DE); JUNGEN, Wolfgang, 52249 Eschweiler (DE); MESCHKE, Frank, 87474 Buchenberg (DE); BASU, Rajendra Nath, Calcutta 100029 (IN)
(86) Internationale Anmeldenummer: PCT/DE2001/004497
(87) Internationale Veröffentlichungsnummer: WO 2002/044103

(56) Entgegenhaltungen:
- DE-A- 19 834 423
- JP-A- 7 187 841
- US-A- 5 196 388
- US-A- 5 534 468
- US-A- 5 614 127
- STAMBOLOVA, I. ET AL: "The effect of Ca, Sr, and Ba substitutions on the morphology and electrical resistivity of La1-xAxCu0.5Mn0.5O3 thin films" VACUUM (1996), 47(10), 1239-1242 , XP002196615
- WANG, K. Y. ET AL: "Structural, magnetic, and transport properties in a Cu-doped La0.7Ca0.3MnO3 system" JOURNAL OF APPLIED PHYSICS (2001), 90(12), 6263-6267 , XP002196616
- RALPH, J. M. ET AL: "Materials for lower temperature solid oxide fuel cells" JOURNAL OF MATERIALS SCIENCE (2001), 36(5), 1161-1172 , XP002196617

## Beschreibung

### Technisches Gebiet

Die Erfindung betrifft einen keramischen Werkstoff, insbesondere einen elektrisch leitfähigen keramischen Werkstoff, sowie dessen Herstellung und Verwendung.

### Stand der Technik

Elektrisch leitfähige Keramiken werden typischerweise als Verbindungselemente zwischen Bauteilen eingesetzt. Diese Keramiken gewährleisten einerseits einen elektrischen Kontakt zwischen zwei Bauteilen, mit denen dieses Verbindungselement in Folge eines Fügeprozesses einen innigen stoffschlüssigen Kontakt hat. Andererseits können aus solchen Keramiken elektrische Leitungsbahnen ausgebildet werden, die sich in oder auf einem Bauteil befinden, um entweder infolge des elektrischen Stromes eine physikalisch-chemische Änderung des Bauteils zu induzieren (Aktorfunktion) oder um die Änderungen einer physikalisch-chemischen Eigenschaft des Bauteils in elektrisch meßbare Größen umzuwandeln (Sensorfunktion).

Aus der Literatur sind eine Reihe von Herstellungsverfahren bekannt, die zu niedrig sinternden Keramiken führen. Sehr oft werden Synthesemethoden über Sol-Gel-Zwischenprodukte oder nanophasige Pulver herangezogen, um die Sintertemperaturen von Keramiken zu erniedrigen. Solche Verfahren zeichnen sich aber dadurch aus, daß sie sehr teurer (oft metall-organische) Ausgangs- und Hilfsstoffe bedürfen und meist in sehr geringen Mengen hergestellt werden können, siehe z. B. U.S. Patent 4,636,378.

Eine andere Methode, niedrig sinternde Keramiken zu erhalten, ist aus EP 0 280 033 B1 bekannt. Dabei werden Fällungsreaktionen über z. B. Hydroxide oder Oxalate durchgeführt. Nachteilig hierbei sind oftmals die sich bildenden Salze, die bei komplexen Zusammensetzungen einerseits zur Entmischung neigen oder, wegen unterschiedlicher Löslichkeitsprodukte der Salze, nur unvollständig ausfallen und damit zu abweichenden Stöchiometrien der Produkte führen. Ein weiterer Nachteil ist oftmals die Verwendung von organischen Lösungs- oder Reinigungsmitteln, die das Herstellungsverfahren verteuern.

Weiterhin ist aus US 3,330,697 ein Herstellungsverfahren für Niobate, Zirkonate und Titanate aus Blei und Erdalkalimetallen bekannt. Dabei werden zunächst in einer Lösung aus Polyhydroxyalkohol und Zitronensäure Verbindungen mit Titan, Zirkonium und Niob mit Blei oder Erdalkalisalzen gemischt. Durch Erwärmung der Lösung werden die organischen Komponenten entfernt. Diese Herstellungsweise wird in der Literatur als Pechini-Methode bezeichnet. Diese Methode ist jedoch, wie in der Patentschrift beschrieben, für niedrig sinternde Keramiken nicht geeignet. Die dort verwendeten Polyhydroxyalkohole haben den Nachteil, daß sie die Stammlösung mit den Kationen und der Zitronensäure bei Erwärmung durch Polymerisation in ein zähflüssiges Harz umwandeln. Ferner führt der erhöhte Anteil an organischen Hilfsstoffen dazu, daß es in den genannten Beispielen bei weiterer Temperaturerhöhung zu einer spontanen Verbrennung des zähflüssigen Harzes kommt. Eigene Untersuchungen mit dieser Herstellungsweise, aber auch mit anderen Herstellungsmethoden, die auf unkontrollierbaren Zündungen der Zwischenprodukte basieren, haben gezeigt, daß die Sinterfähigkeit der erhaltenen Keramikpulver sehr eingeschränkt wird. Eine Erwärmung, wie sie die Verbrennung des Harzes darstellt, ist daher für die Herstellung von niedrig sinternden Keramiken unbedingt zu vermeiden.

Aus US 5,534,468 A ist ein Verfahren zur Herstellung eines keramischen Werkstoffes mit der Zusammensetzung La₁₋ₓSrₓCr_{1-y}Mn_{y}O₃ bekannt, bei dem eine kolloidale Lösung aus einem polyhydroxyorganischen Chelatbildner und den entsprechenden Metallsalzen aufgeheizt wird, wobei zunächst ein gemischter Metalloxid-Precursorgel entsteht. Durch Zugabe von Säure und/oder Wasser wird der halbfeste Precursor in ein Sol oder eine flüssiges kolloidale System überführt. Erneutes Aufheizen treibt das Lösungsmittel aus dem Precursor, so dass ein dickflüssiges, viskoses Gel erhalten wird, welches zur weiteren Verwendung gegossen, gezogen oder extrudiert werden kann.

In JP 07 187841 A wird eine Tabelle mit keramischen Werkstoffe mit einer Perowskitstruktur offenbart, bei der die Werkstoffe entweder Co oder Cu enthalten. Dabei handelt es sich bei den dort genannten Werkstoffen um poröse Sintermaterialien mit der allgemeinen Formel La₁₋ₓAₓMn_{1-y}B_{y}O₃, bei denen Teile des Mangans durch z. B.

Co oder Cu ausgetauscht wurden. Ziel dieses Austausches ist es, ein Sintermaterial zu schaffen, welches pro Aufheizzyklus bis 1000 °C eine Schrumpfung von weniger als 0,01 % aufweist. Die Sintertemperaturen der Werkstoffe liegen dabei zwischen 600 und 1000 °C.

I. Stambolowa et al. beschreibt in Ihrem Aufsatz "The effect of Ca, Sr, and Ba substitutions on the morpholgy and electrical resistivity of La1-xAxCu0,5Mn0,5O3 thin films" in Vacuum (1996), 47(10), 1239-1242 einen keramischen Werkstoff der allgemeinen Formel La₁₋ₓAₓCu_{0,5}Mn_{0,5}O₃ (A = Ca, Sr, Ba und X = 0,1, 0,2 und 0,3) mit einer Sintertemperatur zwischen 850 und 900 °C. Diese Werkstoffe weisen alle eine Perowskitstruktur auf.

K. Y. Wang et al. berichten in "Structural, magnetic and transport properties in a Cu-doped La0,7Ca0,3MnO3 system" im Journal of Applied Physics (2001), 90(12) 6263-6267 ebenfalls über Cu-haltige keramische Werkstoffe mit der allgemeinen Formel La_{0,7}Ca_{0,3}Mn₁₋ₓCuₓO₃, mit 0 ≤ x ≤ 0,2.

### Aufgabe und Lösung

Aufgabe der Erfindung ist es, einen keramischen Werkstoff zu schaffen, der gegenüber dem Stand der Technik eine verbesserte Sinterfähigkeit und eine geringere Sintertemperatur aufweist. Weiterhin soll der keramische Werkstoff gute elektrische Eigenschaften aufweisen. Ferner ist es die Aufgabe der Erfindung ein Herstellungsverfahren für einen solchen keramischen Werkstoff zu schaffen.

### Darstellung der Erfindung

Bei dem erfindungsgemäßen Verfahren werden wenigstens zwei verschiedene Metallnitrate oder -karbonate in einer wäßrigen Lösung zusammen mit einem Metallkomplexbildner gelöst, eingeengt und bei niedrigen Temperaturen zu einem Feststoff umgesetzt.

Bei den Metallen handelt es sich um wenigstens ein Metall aus einer ersten Gruppe A' = (Y, Sc, Ce, La, Pr, Nd, Sm, Eu, Gd) und wenigstens ein Metall aus einer zweiten Gruppe B = (Ti, V, Cr, Mn, Fe, Co, Ni, Cu, Zn, Zr, Nb, Mo, W, Sn, Sb, Pb, Bi). Notwendig sind dabei wenigstens eine Nitrat- und/oder Karbonatverbindung mit Kobalt und eine Nitrat- und/oder Karbonatverbindung mit Kupfer und/oder Wismut.

Als Metallkomplexbildner sind dabei alle in Wasser löslichen Komplexbildner geeignet, welche die oben aufgeführten Metalle komplexieren können und diese damit als Metallionen in Lösung bringen. Dazu zählen insbesondere die Milchsäure, die Zitronensäure, Zitronensäureester oder auch die Weinsäure. Weiterhin geeignet sind auch andere Polykarbonsäuren, Polyhydroxikarbonsäuren oder Polyaminokarbonsäuren, wie beispielsweise EDTA (Ethylen-diamin-tetra-essigsäure).

Die Lösung aus Metallkomplexbildner und Metallsalzen wird derart erwärmt, daß sich der Metallkomplexbildner zersetzt. Dies kann beispielsweise durch Abspaltung von gasförmigem Kohlenmonoxid oder -dioxid (CO, CO₂) oder auch gasförmigen Stickoxiden (NOₓ) geschehen. Durch die Erwärmung wird gleichzeitig das Wasser der wäßrigen Lösung verdampft, so daß die zunächst gelösten bzw. komplexierten Metallionen einen Feststoff bilden.

In einer vorteilhaften Ausgestaltung des Verfahrens wird wenigstens ein weiteres Metall der Gruppe A" = (Mg, Ca, Sr, Ba) als Nitrat oder als Karbonat in der wäßrigen Lösung gelöst.

In einer vorteilhaften Ausführungsform des Verfahrens werden die Metallverbindungen in einem vorgegebenen Verhältnis eingesetzt. Dabei entspricht die Stöchiometrie der Metalle der einer Keramik mit folgenden Zusammensetzungen: ABO₃, A₂BO₄ oder A₂B₂O₇, wobei A für Elemente aus den genannten Gruppen A' und A*''* und B für die genannten Elemente der Gruppe B steht, wobei Co und Cu und/oder Bi zwingend erforderlich sind.

Es hat sich weiterhin als vorteilhaft herausgestellt, wenn bei dem erfindungsgemäßen Verfahren verschiedene Metalle der Gruppe B in unterschiedlichen Verhältnissen eingesetzt werden. Dabei haben sich insbesondere die folgenden Zusammensetzungen als besonders günstig erwiesen:

| | Zusammensetzung: | Kurzbezeichnung in Figur 2: |
|---|---|---|
| a) | La_{0,8}Ca_{0,2}Cr_{0,1}Co_{0,6}Cu_{0,3}O₃ | LCC-A |
| b) | La_{1,6}Ca_{0,4}Cr_{0,1}Co_{0,6}Cu_{0,3}O₄ | |
| c) | La_{0,8}Ca_{0,2}Cr_{0,1}Co_{0,3}Cu_{0,6}O₃ | LCC-B |
| d) | La_{0,8}Ca_{0,2}Cr_{0,1}Co_{0,5}Bi_{0,1}Cu_{0,3}O₃ | LCC-C |
| e) | La_{0,6}Y_{0,2}Ca_{0,2}Mn_{0,2}Fe_{0,3}Cu_{0,3}Cu_{0,2}O₃ | |
| f) | La_{0,4}Y_{0,4}Ca_{0,2}(Mn_{0,8}Co_{0,1}Cu_{0,1})_{0,9}O₃ | LCC-D |
| g) | La_{0,75}Bi_{0,05}Ca_{0,2}Mn_{0,3}CO_{0,4}Cu_{0,3}O₃ | |
| h) | La(Mn_{0,45}Co_{0,35}Cu_{0,2})O₃ | LCC-F |
| i) | LaMn_{0,35}Co_{0,45}Cu_{0,2}O₃ | |
| j) | La_{0,8}Ca_{0, 2} (Pb, Zr, Ti) _{0,2}Co_{0,5}Cu_{0,3}O₃ | |
| k) | La₀,₉₅Ca₀,₀₅ (Pb, Zr, Ti)₀,₂Co₀,₅Cu₀,₃O₃ | |
| l) | La (Pb, Zr, Ti)₀,₁Mn₀,₃Co₀,₄₅CU_{0,15}O₃ | |
| m) | Y_{0,5}Ca_{0,5}Mn_{0,4}Co_{0,4}Cu_{0,2}O₃ | |
| n) | Y₀,₅Ba_{0,5}Mn_{0,3}Co_{0,4}Ti_{0,15}Cu_{0,15}O₃ | |

Die unter a) bis i) bezeichneten Zusammensetzungen sind vorteilhaft für die Anwendung in einer Brennstoffzelle geeignet, während die unter j) bis n) beschriebenen Zusammensetzungen vorteilhaft für die Anwendung von Piezokeramiken sind.

Die Erwärmung der wässrigen Lösung wird insbesondere zunächst langsam durchgeführt, bis der Hauptteil des Wassers verdunstet ist. Anschließend wird die Temperatur weiter erhöht, insbesondere auf bis zu 700°C. Bei diesen Temperaturen setzt sich der erfindungsgemäße Werkstoff dann vorteilhaft in einen Perowskiten, bzw. in eine mehrphasige Keramik um, die als Hauptkomponente einen Perowskiten aufweist.

Der erfindungsgemäße keramische Werkstoff nach Anspruch 1 wird nach dem erfindungsgemäßen Verfahren hergestellt und weist die folgende Zusammensetzung auf: A'_{1-x-y} A''ₓ B'_{1-a-b} B''ₐ B'''_{b} O₃
mit
- A': = ein oder mehrere Elemente aus der Gruppe (Y, La, Pr, Nd,)
- A": = ein oder mehrere Elemente aus der Gruppe (Mg, Ca, Sr, Ba)
- B': = Co oder eine Mischung aus Co mit einem oder mehreren Elementen der Gruppe (Mn, Fe)
- B'': = ein oder mehrere Elemente aus der Gruppe (Ti, V, Cr, Ni, Zn, Pb, Sb, W, Zr)
- B''': = ein oder mehrere Elemente aus der Gruppe (Cu, Bi)
- und: 0 ≤ x ≤ 0,4, 0 ≤ y ≤ 0, 1,
0 ≤ a < 0,4, 0,15 < b ≤ 0,6,
(1-a-b) ≥ 0,3 und Co ≥ 0,3.

Der Werkstoff ist elektrisch leitfähig und weist regelmäßig eine deutlich verbesserte Sinterfähigkeit auf im Vergleich zu konventionellen Keramiken. Unter einer verbesserten Sinterfähigkeit ist zum einen ein erniedrigter Temperaturbereich für die Sinterung zu verstehen, die im Bereich ab 800 °C und deutlich unterhalb von 1000 °C liegt. Andererseits weisen solche Werkstoffe eine kleinere Korngrößenverteilung auf, als nach dem Stand der Technik für solche Werkstoff bekannt ist. Die typische Größenordnung der Einzelpartikel (Anteil > 80 %) liegt im Bereich von 0,2 bis 7 µm, mit einem mittleren Partikeldurchmesser von 1 bis 2 µm. Diese kleinen Korngrößen führen regelmäßig zu einer deutlich verbesserten Homogenität der Keramik während des Sintervorgangs. Gleichzeitig führt dies regelmäßig zu einer Schrumpfung von mindestens 15 %.

Weiterhin kann durch geeignete Auswahl der eingesetzten Metalle ein kleiner thermischer Ausdehnungskoeffizient im Bereich von 1 * 10⁻⁶ K⁻¹ bis 16 * 10⁻⁶ K⁻¹, insbesondere zwischen 3,5 * 10⁻⁶ K⁻¹ und 13 * 10⁻⁶ K⁻¹ nahezu beliebig eingestellt werden. Das trifft in besonderer Weise für die Beispielzusammensetzungen j), l) und n) zu.

Das Einstellen des thermischen Ausdehnungskoeffizienten ist besonders dann von Vorteil, wenn der erfindungsgemäße Werkstoff als Verbindungselement entweder bei Hochtemperatur-Brennstoffzellen oder zusammen mit Piezo- oder Dielektrika eingesetzt wird. Deren thermischer Ausdehnungskoeffizient liegt bei Temperaturen zwischen 20 °C und 600 °C in einem Bereich von ca. 3,5 bis 6,5 * 10⁻⁶ K⁻¹. Schichten mit solcherweise angepassten thermischen Ausdehnungskoeffizienten führen dann regelmäßig zu weniger mechanischen Spannungen als bei herkömmlichen Verbindungselementen, wie beispielsweise aus Silber, Palladium oder Platin. Diese weisen im selben Temperaturintervall einen wesentlich größeren Ausdehnungskoeffizienten auf (22, 5*10⁻⁶ K⁻¹ für Ag, 13,5*10⁻⁶ K⁻¹ für Pd und 9,8*10⁻⁶ K⁻¹ für Pt). Ferner enthalten die genannten Beispielzusammensetzungen j), k) und 1) Elemente aus Piezo- und Dielektrika, so daß eine sehr gute chemische Kompatibilität und geringe piezo- und dielektrische Eigenschaften regelmäßig eine verbesserte Langzeitstabilität der Keramik gewährleisten.

Vorteilhaft können die erfindungsgemäßen Keramiken z. B. in Piezoelektrika (Aktoren oder Sensoren) eingesetzt werden, die in der Regel aus Bariumtitanat oder Blei-Zirkonium-Titan-Oxid (PbZr₁₋ₓTiₓO₃, abgekürzt PZT) bestehen. Diese beiden Stoffklassen bestehen, ebenso wie eine vorteilhafte Ausgestaltung der erfindungsgemäßen Keramik, aus Perowskiten.

Liegt der Werkstoff als Perowskit vor, weist dieser geringe piezoelektrische Eigenschaften auf, so daß während einer mechanischen Beanspruchung eines daraus gefertigten Bauteils geringere Spannungen zwischen einzelnen Komponenten entstehen und somit zu einer längeren Lebensdauer der Bauteile beitragen.

Der erfindungsgemäße Werkstoff ist weiterhin besonders für die Verwendung als elektrisch leitendes Verbindungselement geeignet, insbesondere bei Metall-Metall-, Metall-Keramik- oder Keramik-Keramik-Verbünden.

Ein Verbindungselement aus dem erfindungsgemäßen Werkstoff ist ferner für den Einsatz in Hochtemperatur-Brennstoffzellen (SOFC) geeignet, in denen diese Keramiken eine feste Fügung zwischen metallischer bipolarer Platte und der Kathode erzeugen. Diese erfindungsgemäßen keramischen Werkstoffe können dabei Edelmetalle, wie Silber, Palladium oder Platin als elektrisch leitfähige Kontakte ersetzen. Hierbei ergibt sich eine Verbesserung des Standes der Technik allein durch geringere Werkstoffpreise.

Vorteilhaft ist, daß die Aufbringung und Fügung zwischen PZT-Keramiken und den erfindungsgemäßen Verbindungswerkstoffen leicht zu realisieren ist. Werden konventionelle PZT-Keramiken verwendet, werden diese im allgemeinen bei etwa 1200 °C gesintert. Ein Fügeprozeß bei 800 - 1000 °C ist somit ohne weiteres zu realisieren. Niedrig sinternde PZT-Keramiken mit Sintertemperaturen unterhalb von 1000 °C lassen sich ferner gemeinsam mit den erfindungsgemäßen Werkstoffen sintern, und es ist möglich, dadurch einen Prozeßschritt, d. h. eine Temperaturbehandlung, zu sparen.

### Figuren und Ausführungsbeispiele

Im folgenden wird die Erfindung anhand von Figuren und Ausführungsbeispielen näher erläutert. Es zeigt:
- Figur 1:: Röntgenbeugungsdiagramm eines perowskitischen Keramikpulvers (LCC-A) nach einer Temperaturbehandlung von 3 Stunden bei 900 °C.
- Figur 2:: Korngrößenverteilung der perowskitischen Keramikpulver.
- Figur 3:: Sinterkurven von fünf perowskitischen Keramikproben bis 900 °C. Die höchsten Schrumpfungsraten treten ab etwa 850 °C auf.
- Figur 4:: Gefüge einer siebgedruckten Kontaktschicht (LCC-B) nach Sinterung bei 900 °C für 2 Stunden.
- Figur 5:: Schrumpfungsverhalten von Glaskeramiken bis 900 °C (offene Symbole) und einer keramischen Kontaktpaste LCC-B (gefüllte Symbole) unter leichter Druckbelastung zur Simulation eines Brennstoffzellen-Fügeprozesses.

### Ausführungsbeispiel 1:

Als 1. Ausführungsbeispiel wird die Herstellung einer 100 g Pulvercharge mit der Sollzusammensetzung von La_{0.8} Ca_{0.2} Cr_{0.1} Co_{0.6} Cu_{0.3} O₃ beschrieben. Als Ausgangssalze wurden folgende Chemikalien eingesetzt:

| | |
|---|---|
| La (NO₃)₃ x 6H₂O | = 152,7 g |
| Ca (NO₃)₂ x 4H₂O | = 20,8 g |
| Cr (NO₃) ₃ x 9H₂O | = 17 , 7 g |
| Co (NO₃) ₂ x 6H₂O | = 77,0 g |
| Cu (NO₃) ₂ x3H₂O | = 32,0 g |
| Zitronensäure-Monohydrat | = 170,0 g |

Die abgewogenen Salze werden in wenig destilliertem Wasser - nur soviel wie nötig - unter Rühren in ein Quarzgefäß mit flachem Boden gelöst. Nach vollständiger Auflösung der Salze wird die doppelte Molmenge an Zitronensäure hinzugefügt und ebenfalls in Lösung gebracht, um die Kationen zu komplexieren.

Die Mischung wird auf einer Heizplatte eingedampft, bis eine viskose Masse entstanden ist. Anschließend wird mit einem Gasbrenner die Temperatur vorsichtig weiter erhöht, bis eine feste Masse vorliegt. Hierbei kann in dieser Phase die Mischung wegen beginnender Zersetzung der Zitronensäure zu starkem Aufschäumen neigen. Die Mischung wird anschließend in einem Kammerofen bei einer Aufheizrate von 3 K/min für 3 Std. bei 700 °C an Luft kalziniert.

Das so erhaltene Pulver wird anschließend in einer Planetenmühle (PM) gemahlen, um größere Agglomerate zu zerstoßen. Als geeignete Mahlbedingungen für diese Menge an Pulver haben sich 2 Stunden in Ethanol bei 6000 U/min in ZrO₂-Mahlbeche und Mahlkugeln ∅ 1 cm bewährt.
Es folgen weitere spezielle Ausführungsformen des erfindungsgemäßen Werkstoffes im Zusammenhang mit möglichen vorteilhaften Einsatzgebieten.

### Ausführungsbeispiel 2: Verwendung in einer Hochtemperatur-Brennstoffzelle

Eine Hochtemperatur-Brennstoffzelle setzt sich im allgemeinen aus folgenden Komponenten zusammen:
Einem Elektrolyten aus Yttriumoxid-stabilisiertem Zirkoniumoxid (YSZ), einer Kathode aus Lanthanmanganit und einer Anode aus dem Verbundwerkstoff Ni und YSZ.
Um eine genügend große Leistung zu erzeugen, werden die einzelnen Zellen miteinander seriell zu einem Zellenstapel verschaltet. Als elektrisch verbindendes Bauteil, dem sogenannten Interkonnektor, eignen sich dazu Legierungen auf Fe-Cr-Basis. Mit Hilfe von keramischen Pasten aus den oben beschriebenen Pulvern werden die einzelnen Zellen miteinander verbunden, um gleichzeitig Fertigungstoleranzen auszugleichen. Hierzu wird der Zellenstapel in einem Fügeprozeß einer Temperaturbehandlung unterzogen, wobei die Pasten aushärten und sich aufgrund von Diffusionsprozessen fest mit den benachbarten Zellenkomponenten verbinden. Die Verbindungselemente besitzen unter den Betriebsbedingungen der Brennstoffzelle hohe elektrische Leitfähigkeit, an die übrigen Zellkomponenten angepaßte thermischer Ausdehnungskoeffizienten, chemische Stabilität und
Kompatibilität mit den benachbarten Zellenkomponenten, da sie ähnliche chemische Zusammensetzungen aufweisen wie die Kathode.

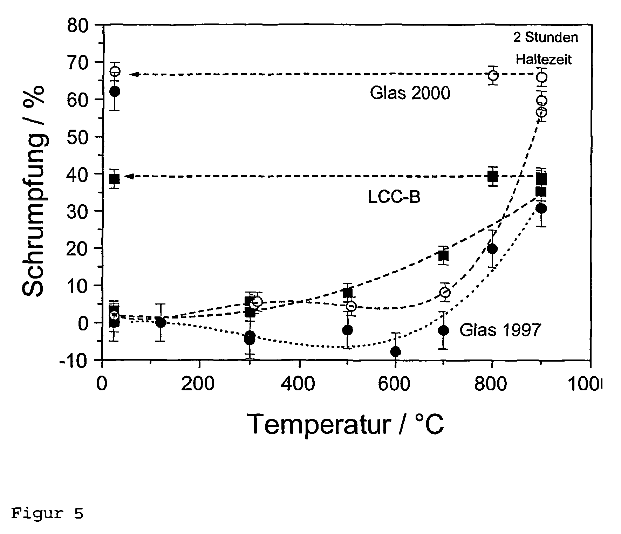

Während des Fügeprozesses kann, aufgrund der guten Sinterfähigkeit der Verbindungselemente, die Schwindung der sich bildenden Schicht sehr gut an die Schwindung der gleichzeitig sinternden Glaskeramik angepaßt werden, die für die Abdichtung der Gasräume zwischen Anode und Kathode erforderlich ist (siehe Figur 5).

Eine spezielle Ausführungsform des Erfindungsgedankens betrifft daher einen keramischen Werkstoff, welcher als Verbindungsschicht auf den Interkonnektor oder auf die Kathode aufgebracht wird.

Als besonders günstige Zusammensetzungen haben sich bisher Verbindungen der Zusammensetzungen

*A*'_{1-x-y} *A*"ₓ Mn_{1-a-b} *B*"ₐ Cu_{b} O₃ bewährt,

mit
- *A'* =: *(La, Pr, Nd)*
- *A*'' =: *(Ca, Sr)*
- *B*'' =: *Co oder eine Mischung aus Co und Mn und*/*oder Fe*
- *x* =: =*0* - *0,4 y* = *0 - 0,1*
- *a* =: *0* - *0, 4 b* = *0, 15 - 0, 6*
*und mit (1-a-b) ≥ 0, 3*.

Da sich während der Hochtemperaturbeanspruchung an der Grenzschicht zwischen Verbindungselement und Stahl unter anderem auch Chromate, wie CaCrO₄, bilden, wird der A"-Anteil möglichst klein, insbesondere x = 0, gewählt. Diese Auswahl hängt jedoch wesentlich von den erforderlichen Leitfähigkeiten ab, die mit abnehmendem A "-Anteil ebenfalls abnehmen.

### Ausführungsbeispiel 3: Verwendung bei Piezokeramiken, z. B. als Kontaktierung für Sensoren und Aktoren.

Für die PZT-Keramiken werden kleinere thermische Ausdehnungskoeffizienten realisiert als für die Anwendung in Hochtemperatur-Brennstoffzellen. Hierfür sind vermehrt Anteile von Y und Cr anzuwenden. Zu hohe Yttrium-Anteile senken allerdings die Leitfähigkeit zu sehr. Dieser Effekt kann durch Erhöhung des A' '-Anteils jedoch kompensiert werden.

Die Variationsbreite der Zusammensetzungen kann wie folgt zusammengefaßt werden:

A'_{1-x-y-z} Y_{z} A' 'ₓ Mn_{1-a-b} *M*' 'ₐ Cu_{b} O₃

mit
- *A'* =: *(La, Pr, Nd)*
- *A'' =*: *(Ca, Sr, Ba)*
- *M'' =*: *Co mit 0 > a ≥ 0,3 b = 0, 1 - 0, 6*
- *x* =: *0 - 0,8 y = 0 - 0,05 z = 0,1 - 0,8*.

Vorteilhaft sind ferner Zusätze von B'' = (Pb, Zr, Ti) mit einem Anteil von bis zu 0,2 (siehe dazu auch die Beispielzusammensetzungen k) bis m)). Zusätze in dieser Größenordnung setzen die chemischen Diffusionsgradienten herab und vermindern so eine chemische Wechselwirkung zwischen Verbindungselement und PZT-Keramik.

Die Materialien können nach bekannten Verfahren mit Hilfe der Siebdrucktechnik zu Leiterbahnen in oder auf Aktoren oder Sensoren verarbeitet werden, wobei der Fügeprozeß nach der Herstellung des Keramikkörpers oder gleichzeitig mit der Herstellung erfolgen kann.

### Beschreibung der Figuren

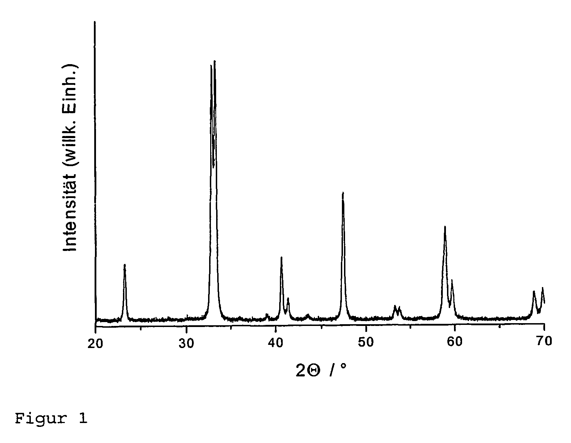

Die Figur 1 zeigt das Röntgenbeugungsdiagramm des im Ausführungsbeispiel 1 genannten Pulvers (LCC-A) nach einer Temperaturbehandlung von 3 Stunden bei 900 °C. Das auftretende Beugungsmuster ist der Perowskitstruktur zuzuordnen, zusätzliche Röntgenreflexe anderer kristalliner Phasen sind nicht erkennbar. Bei höheren Kupferkonzentrationen bilden sich komplexe Kuprate, die aber ebenfalls eine hohe Leitfähigkeit besitzen und einer Anwendung nicht hinderlich sind.

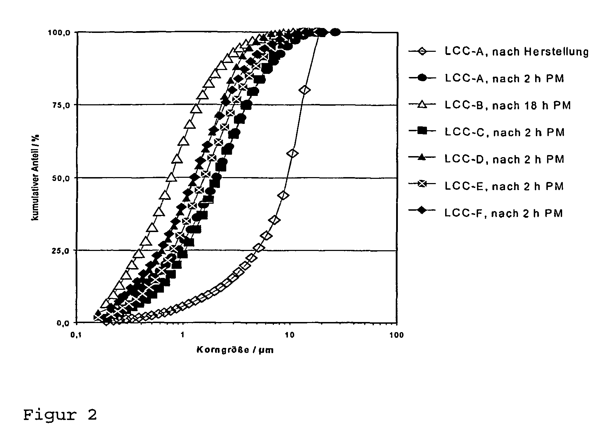

In Figur 2 sind die Korngrößenverteilungen von Pulvern mit verschiedener Zusammensetzung dargestellt. Nach der Herstellung liegen Korn-Agglomerate mit einem Durchmesser bis zu etwa 20 µm vor, die nach kurzer Mahldauer von 2 Stunden in einer Planetenmühle (PM) zerstört sind. Die Pulver weisen dann jeweils sehr einheitliche Korngrößenverteilungen mit mittleren Korngrößen (d₅₀) von 1-2 µm auf. Bei weiterer Mahlung in einer Planetenmühle erreichen die mittleren Partikelgrößen mit ca. 0,8 µm nur geringfügig kleinere Werte. Insgesamt weisen regelmäßig über 80 % der Partikel eine Partikelgröße zwischen 0,2 und 7 µm auf.

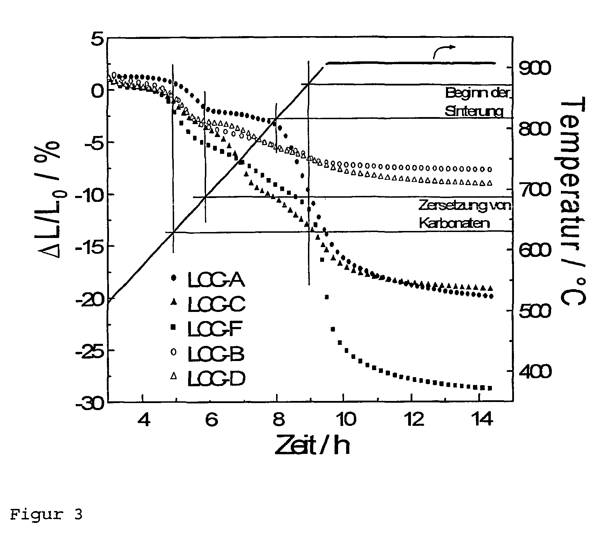

Figur 3 zeigt beispielhaft fünf Sinterkurven perowskitischer Keramikproben, die an gepreßten Probekörpern gemessen wurden. Eine anfängliche Schrumpfung bei 600-700 °C ist auf die Zersetzung von Karbonatresten in den kalzinierten Pulvern zurückzuführen, die sich bei der Zersetzung der Zitratsalze bilden können. Bei höheren Temperaturen setzt die eigentliche Schwindung zwischen 800 und 900 °C ein. Bereits bei 900 °C ergeben sich Längenschrumpfungen zwischen 20 und 30 %.

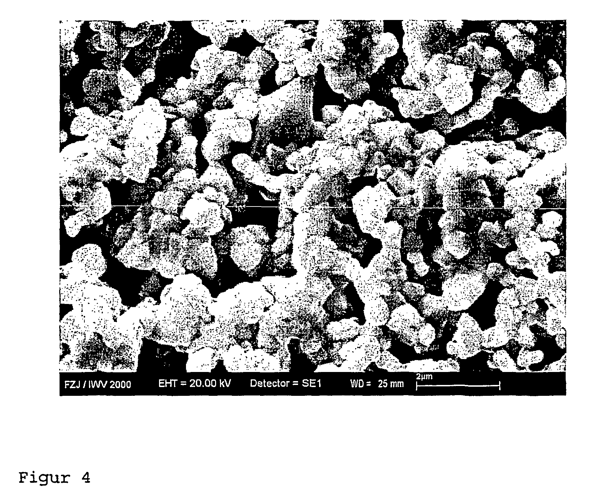

Die Morphologie einer Sinterprobe, die aus einer keramischen Paste des oben genannten Kontaktierungsmaterials (LCC-B) besteht und bei 900 °C für zwei Stunden gesintert wurde, ist in Figur 4 wiedergegeben. Die einzelnen Keramikpartikel sind bereits bei dieser Temperatur sehr gut miteinander versintert und bilden ein stabiles, durchgehendes Netzwerk mit hoher Leitfähigkeit. Die Primärkörner der Keramik haben einen mittleren Durchmesser von 0,5-1 µm.

Figur 5 zeigt Messungen des Schrumpfungsverhaltens an gepreßten Probekörpern. Die in Figur 4 wiedergegebenen Längenänderungen zeigen zwar das Potential der Materialien und deren tendenzielles Sinterverhalten, die Schwindung beispielsweise während eines Fügeprozesses einer Hochtemperatur-Brennstoffzelle kann jedoch nur unter realitätsnahen Bedingungen getestet werden. Für diesen Zweck wurde eine solche Brennstoffzelle mit einer Paste aus dem Kontaktierungsmaterial LCC-A aus dem Ausführungsbeispiel 1 beschichtet, mit einem Glaslot abgedichtet und zwischen ober- und unterseitigen Interkonnektorplatten zur Simulation einer Zellenstapelung in einen Ofen mit optischer Beobachtungsvorrichtung gesetzt. Während des Fügens wurde eine geringe Last auf den Komponentenverbund aufgebracht, und die Änderung der Kontaktschicht- und Glaslotdicke gemessen. Aus den Kurvenverläufen der Figur 5 ist ersichtlich, dass bei einem realen Einsatz die Kontaktschicht um ca. 40 % schwindet. Ferner ist die Schwindung der Keramik gut an das Sinterverhalten der verwendeten Glaslote angepaßt.

## Patentansprüche

1. Keramischer Werkstoff mit einer Sintertemperatur unterhalb von 1000°C und einer Perowskitstruktur mit der stöchiometrischen Zusammensetzung:
A' _{1-x-y} A"ₓ B'_{1-a-b} B"ₐ B"'_{b} O₃
mit
A' = ein oder mehrere Elemente aus der Gruppe (Y, La, Pr, Nd,)
A" = ein oder mehrere Elemente aus der Gruppe (Mg, Ca, Sr, Ba)
B' = Co oder eine Mischung aus Co mit einem oder mehreren Elementen der Gruppe (Mn, Fe)
B'' = ein oder mehrere Elemente aus der Gruppe (Ti, V, Cr, Ni, Zn, Pb, Sb, W, Zr)
B''' = ein oder mehrere Elemente aus der Gruppe (Cu, Bi)
und 0 ≤ x ≤ 0,4, 0 ≤ y ≤ 0,1,
0 ≤ a < 0,4, 0,15 < b ≤ 0,6,
(1-a-b) ≥ 0,3 und Co mindestens 0,3.

2. Keramischer Werkstoff nach Anspruch 1, der La als Element auf der A'-Position aufweist.

3. Keramischer Werkstoff nach einem der vorhergehenden Ansprüche 1 bis 2, der Cu als Element auf der B"'-Position aufweist.

4. Keramischer Werkstoff nach einem der vorhergehenden Ansprüche 1 bis 3, der Y zumindest als ein Element auf der A'-Position aufweist.

5. Keramischer Werkstoff nach einem der Ansprüche 1 bis 4, der beim Aufheizen bis zu Temperaturen von 900 °C eine Schrumpfung von wenigstens 15 %, insbesondere von bis zu 20% aufweist.

6. Keramischer Werkstoff nach Anspruch 1, mit einer der nachfolgenden stöchiometrischen Zusammensetzungen:
| A' | A'' | B' | B'' | B''' | O₃ |
|---|---|---|---|---|---|
| La_{0,8} | Ca_{0,2} | Co_{0,6} | Cr_{0,1} | Cu_{0,3} | O₃ |
| La_{1,6} | Ca_{0,4} | Co_{0,6} | Cr_{0,1} | Cu_{0,3} | O₄ |
| La_{0,8} | Ca_{0,2} | Co_{0,3} | Cr_{0,1} | Cu_{0,6} | O₃ |
| La_{0,8} | Ca_{0,2} | Co_{0,5} | Cr_{0,1} | Bi_{0,1}Cu_{0,3} | O₃ |
| La_{0,6}Y_{0,2} | Ca_{0,2} | Mn_{0,2}Fe_{0,3}Co_{0,3} | | Cu_{0,2} | O₃ |
| La_{0,75} | Ca_{0,2} | Mn_{0,3}Co_{0,4} | | Cu_{0,3} Bi_{0,05} | O₃ |
| La | | Mn_{0,45}Co_{0,35} | | Cu_{0,2} | O₃ |
| La_{0,8} | Ca_{0,2} | Co_{0,5} | (Pb,Zr,Ti)_{0,2} | Cu_{0,3} | O₃ |
| La_{0,95} | Ca_{0,05} | Co_{0,5} | (Pb,Zr,Ti)_{0,2} | Cu_{0,3} | O₃ |
| La | | Mn_{0,3}Co_{0,45} | (Pb,Zr,Ti)_{0,1} | Cu_{0,15} | O₃ |
| Y_{0,5} | Ca_{0,5} | Mn_{0,4}Co_{0,4} | | Cu_{0,2} | O₃ |
| La | | Mn_{0,35}Co_{0,45} | | Cu_{0,2} | O₃ |

7. Verwendung des Werkstoffs gemäß einem der vorhergehenden Ansprüche 1 bis 6 als Verbindungselement für eine Brennstoffzelle.

8. Verwendung des Werkstoffs gemäß einem der vorhergehenden Ansprüche 1 bis 6 als Kontaktelement für eine Piezokeramik.

9. Verfahren zur Herstellung eines keramischen Werkstoffs gemäß einem der Ansprüche 1 bis 6 mit den Schritten:
a) in einer wässrigen Lösung umfassend einen Metallkomplexbildner wird
wenigstens eine Verbindung aus der Gruppe *A*' = (Y, La, Pr, Nd) als Nitrat und/oder Karbonat, und
wenigstens eine zweite Verbindung aus der Gruppe B = (Ti, V, Cr, Mn, Fe, Co, Ni, Cu, Zn, Bi, Pb, Sb, W, Zr) als Nitrat oder Karbonat gelöst, wobei eine Verbindung mit Co und Cu und/oder eine Verbindung mit Co und Bi zwingend sind;
b) die wässrige Lösung wird erwärmt, wobei sich der Metallkomplexbildner zersetzt und der keramischer Werkstoff gebildet wird.

10. Verfahren nach vorhergehendem Anspruch 9, bei dem wenigstens eine dritte Verbindung aus der Gruppe *A' '* = (Mg, Ca, Sr, Ba) als Nitrat und/oder Karbonat in der wässrigen Lösung gelöst wird.

11. Verfahren nach einem der vorhergehenden Ansprüche 9 bis 10, bei dem eine Polykarbonsäure als Metallkomplexbildner eingesetzt wird.

12. Verfahren nach einem der vorhergehenden Ansprüche 9 bis 11, bei dem Zitronensäure als Metallkomplexbildner eingesetzt wird.

13. Verfahren nach einem der vorhergehenden Ansprüche 9 bis 12, bei dem bis zu 700 °C erwärmt wird.

## Claims

1. Ceramic material having a sintering temperature of less than 1000°C and a perovskite structure of the following stoichiometric composition:
A'_{1-x-y} A" ₓ B' _{1-a-b} B" ₐ B"' _{b} O₃
where
A' = one or more elements from the group (Y, La, Pr, Nd),
A'' = one or more elements from the group (Mg, Ca, Sr, Ba)
B' = Co or a mixture of Co and one or more elements from the group (Mn, Fe),
B'' = one or more elements from the group (Ti, V, Cr, Ni, Zn, Pb, Sb, W, Zr)
B "' = one or more elements from the group (Cu, Bi),
and 0 ≤ x ≤ 0.4, 0 ≤ y ≤ 01,
0 ≤ a < 0.4, 0.15 < b ≤ 0.6,
(1-a-b) ≥ 0.3 and Co is at least 0.3.

2. Ceramic material according to claim 1, which has La as an element in the A' position.

3. Ceramic material according to either of foregoing claims 1 and 2, which has Cu as an element in the B' ' ' position.

4. Ceramic material according to one of foregoing claims 1 to 3, which has Y at least as an element in the A' position.

5. Ceramic material according to one of claims 1 to 4, which, when heated to temperatures of 900°C, shows a shrinkage of at least 15%, and in particular of up to 20%.

6. Ceramic material according to claim 1, having one of the following stoichiometric compositions:
| A' | A'' | B' | B'' | B''' | O₃ |
|---|---|---|---|---|---|
| La_{0.8} | Ca_{0.2} | Co_{0.6} | Cr_{0.1} | CU_{0.3} | O₃ |
| La_{1.6} | Ca_{0.4} | Co_{0.6} | Cr_{0.1} | Cu_{0.3} | O₄ |
| La_{0.8} | Ca_{0.2} | Co_{0.3} | Cr_{0.1} | Cu_{0.6} | O₃ |
| La_{0.8} | Ca_{0.2} | Co_{0.5} | Cr_{0.1} | Bi_{0.1}Cu_{0.3} | O₃ |
| La_{0.6}Y_{0.2} | Ca_{0.2} | Mn_{0.2}Fe_{0.3}Co_{0.3} | | Cu_{0.2} | O₃ |
| La_{0.75} | Ca_{0.2} | Mn_{0.3}Co_{0.4} | | Cu_{0.3}Bi_{0.05} | O₃ |
| La | | Mn_{0.45}Co_{0.35} | | Cu_{0.2} | O₃ |
| La | | Mn_{0.35}Co_{0.45} | | Cu_{0.2} | O₃ |
| La_{0.8} | Ca_{0.2} | Co_{0.5} | (Pb, Zr, Ti)_{0.2} | Cu_{0.3} | O₃ |
| La_{0.95} | Ca_{0.05} | Co_{0.05} | (Pb, Zr, Ti)_{0.2} | Cu_{0.3} | O₃ |
| La | | Mn_{0.3}Co_{0.45} | (Pb, Zr, Ti)_{0.1} | Cu_{0.15} | O₃ |
| Y_{0.5} | Ca_{0.5} | Mn_{0.4}Co_{0.4} | | Cu_{0.2} | O₃ |

7. Use of the material according to one of foregoing claims 1 to 6 as a connecting member for a fuel cell.

8. Use of the material according to one of foregoing claims 1 to 6 as a contact member for a piezo-ceramic.

9. Method of producing a ceramic material according to one of claims 1 to 6, having the following steps:
a) at least one compound from the group A' = (Y, La, Pr, Nd) in the form of a nitrate or carbonate, and at least one second compound from the group *B* = (Ti, V, Cr, Mn, Fe, Co, Ni, Cu, Zn, Bi, Pb, Sb, W, Zr) in the form of a nitrate or carbonate are dissolved in an aqueous solution comprising a metal-complex forming agent, a compound having Co and Cu and/or a compound having Co and Bi being mandatory,
b) the aqueous solution is heated, the metal-complex forming agent being decomposed and the ceramic material being formed.

10. Method according to foregoing claim 9, wherein at least one third compound from the group *A*" = (Mg, Ca, Sr, Ba) in the form of a nitrate and/or carbonate is dissolved in the aqueous solution.

11. Method according to either of foregoing claims 9 and 10, wherein a polycarboxylic acid is used as a metal-complex forming agent.

12. Method according to one of foregoing claims 9 to 11, wherein citric acid is used as a metal-complex forming agent.

13. Method according to one of foregoing claims 9 to 12, wherein heating takes place to 700°C.

## Revendications

1. Matériau céramique ayant une température de frittage inférieure à 1.000°C et une structure perovskite ayant la composition stoechiométrique :
A'_{1-x-y}A"ₓB'_{1-a-b}B"ₐB"'_{b}O₃
avec
A' = un ou plusieurs éléments du groupe (Y, La, Pr, Nd)
A" = un ou plusieurs éléments du groupe (Mg, Ca, Sr, Ba)
B' = Co ou un mélange de Co avec un ou plusieurs éléments du groupe (Mn, Fe)
B" = un ou plusieurs éléments du groupe (Ti, V, Cr, Ni, Zn, Pb, Sb, W, Zr)
B'" = un ou plusieurs éléments du groupe (Cu, Bi)
et 0 ≤ x ≤ 0, 4, 0 ≤ y ≤ 0, 1, 0 ≤ a < 0,4, 0,15 < b ≤ 0,6, (1-a-b) ≥ 0,3 et Co au moins égal à 0,3.

2. Matériau céramique suivant la revendication 1, qui a La comme élément à la position A'.

3. Matériau céramique suivant l'une des revendications 1 à 2, qui a Cu comme élément en la position B"'.

4. Matériau céramique suivant l'une des revendications 1 à 3 précédentes, qui a Y au moins comme un élément en la position A'.

5. Matériau céramique suivant l'une des revendications 1 à 4, qui a, par chauffage jusqu'à des températures de 900°C, un retrait d'au moins 15 %, notamment allant jusqu'à 20 %.

6. Matériau céramique suivant la revendication 1, ayant l'une des compositions stoechiométriques suivantes .
| A' | A'' | B' | B" | B"' | O₃ |
|---|---|---|---|---|---|
| La_{0,8} | Ca_{0,2} | Co_{0,6} | Cr_{0,1} | Cu_{0,3} | O₃ |
| La_{1,6} | Ca_{0,4} | Co_{0,6} | Cr_{0,1} | Cu_{0,3} | O₄ |
| La_{0,8} | Ca_{0,2} | Co_{0,3} | Cr_{0,1} | Cu_{0,6} | O₃ |
| La_{0,8} | Ca_{0,2} | Co_{0,5} | Cr_{0,1} | Bi_{0,1} Cu_{0,3} | O₃ |
| La_{0,6}Y_{0,2} | Ca_{0,2} | Mn_{0,2}Fe_{0,3}Co_{0,3} | | Cu_{0,2} | O₃ |
| La_{0,75} | Ca_{0,2} | Mn_{0,3}Co_{0,4} | | Cu_{0,3}Bi_{0,05} | O₃ |
| La | | Mn_{0,45}Co_{0,35} | | Cu_{0,2} | O₃ |
| La | | Mn_{0,35}Co_{0,45} | | Cu_{0,2} | O₃ |
| La_{0,8} | Ca_{0,2} | Co_{0,5} | (Pb,Zr,Ti)_{0,2} | Cu_{0,3} | O₃ |
| La_{0,95} | Ca_{0,05} | Co_{0,5} | (Pb,Zr,Ti)_{0,2} | Cu_{0,3} | O₃ |
| La | | Mn_{0,3}Co_{0,45} | (Pb,Zr,Ti)_{0,1} | Cu_{0,15} | O₃ |
| Y_{0,5} | Ca_{0,5} | Mn_{0,4}Co_{0,4} | | Cu_{0,2} | O₃ |

7. Utilisation du matériau suivant l'une des revendications 1 à 6 précédentes, comme élément de liaison pour une pile à combustible.

8. Utilisation du matériau suivant l'une des revendications 1 à 6 précédentes, comme élément de contact pour une céramique piézoélectrique.

9. Procédé de préparation d'un matériau céramique suivant l'une des revendications 1 à 6, comprenant les stades dans lesquels :
a) on dissout dans une solution aqueuse comprenant un agent de formation d'un complexe métallique
au moins un composé du groupe A' = (Y, La, Pr, Nd) sous la forme d'un nitrate et/ou d'un carbonate, et
au moins un deuxième composé du groupe B = (Ti, V, Cr, Mn, Fe, Co, Ni, Cu, Zn, Bi, Pb, Sb, W, Zr) sous la forme d'un nitrate ou d'un carbonate, un composé ayant du Co et du Cu et/ou un composé ayant du Co et du Bi étant obligatoire ;
b) on chauffe la solution aqueuse jusqu'à ce que l'agent de formation d'un complexe métallique se décompose et que le matériau céramique se forme.

10. Procédé suivant la revendication 9 précédente, dans lequel on dissout un troisième composé du groupe A" = (Mg, Ca, Sr, Ba) sous la forme d'un nitrate et/ou d'un carbonate dans la solution aqueuse.

11. Procédé suivant l'une des revendications 9 à 10. précédentes, dans lequel on utilise un acide polycarboxylique comme agent de formation d'un complexe métallique.

12. Procédé suivant l'une des revendications 9 à 11 précédentes, dans lequel on utilise l'acide citrique comme agent de formation d'un complexe métallique.

13. Procédé suivant l'une des revendications 9 à 12 précédentes, dans lequel on chauffe jusqu'à 700°C.
